# EUROPÄISCHE PATENTSCHRIFT

(11) **EP 1 518 151 B1**
(45) Veröffentlichungstag und Bekanntmachung des Hinweises auf die Patenterteilung: **30.08.2006**
(21) Anmeldenummer: 03762418.6
(22) Anmeldetag: 25.06.2003
(51) Int. Cl.: G03F 7/20

(54) **VERFAHREN UND ANORDNUNG ZUR HANDHABUNG VON RETIKELN**
METHOD AND ARRANGEMENT FOR THE MANIPULATION OF RETICLES
PROCEDE ET DISPOSITIF POUR LA MANIPULATION DE RETICULES

(30) Priorität: 03.07.2002 DE 10229988
(43) Veröffentlichungstag der Anmeldung: 30.03.2005
(73) Patentinhaber: Infineon Technologies AG, 81669 München (DE)
(72) Erfinder: SCHEDEL, Thorsten, 01129 Dresden (DE); SCHUMACHER, Karl, 01099 Dresden (DE)
(74) Vertreter: Adler, Peter
(86) Internationale Anmeldenummer: PCT/DE2003/002108
(87) Internationale Veröffentlichungsnummer: WO 2004/006011

(56) Entgegenhaltungen:
- EP-A- 0 940 721
- EP-A- 1 318 430
- US-A- 5 442 163
- US-A- 5 980 187
- US-A1- 2001 020 643
- US-B1- 6 414 744

## Beschreibung

Die Erfindung betrifft eine Anordnung zur Ein- und Ausgabe von Retikeln in fotolithografischen Prozessen mit einer Magazinaufnahme, in die ein Ein- und Ausgabemagazin, in dem zumindest ein horizontales Aufnahmefach zur Aufnahme eines mit einem Pellikel versehenen Retikels vorgesehen ist, einsetzbar ist, einem Manipulator, einer das Retikelmagazin und/oder den Manipulator relativ zueinander bewegenden Antriebseinheit und einem mit dem Retikel korrespondierenden Sensor der die Antriebseinheit steuernd zumindest mittelbar mit dieser verbunden ist.

Die Erfindung betrifft auch ein Verfahren zur Ein- und Ausgabe von Retikeln in fotolithografischen Prozessen bei dem mit Pellikeln versehene Retikel nach einem Einsetzen eines Ein- und Ausgabemagazines in eine mittels eines Manipulators aus einem Aufnahmefach des Ein- und Ausgabemagazines aufgenommen und dem fotolithografischen Prozess zugeführt werden, wobei von dem Retikel signifikante Daten aufgenommen und mittels dieser Daten die Bewegung des Manipulators gesteuert werden.

In fotolithografischen Prozessen werden Masken oder Retikel insbesondere bei der Herstellung von Halbleiterschaltkreisen verwendet. Auf einem Retikel befindet sich die Abbildung einer Schicht des Halbleiterschaltkreises in Form einer Fotomaske. Hierzu bestehen die Retikel aus einer Glasplatte, die die Fotomaske trägt.

In einem Belichtungsschritt werden dann diese Abbildungen auf eine Fotolackschicht einer Halbleiterscheibe gebracht, wodurch eine Lackmaske auf der Halbleiterscheibe entwickelt werden kann, die dann der weiteren Strukturierung der Halbleiterscheibe zur Herstellung der Halbleiterschaltkreise dient.

In aller Regel werden die Abbildungen in einem Waferstepper/scanner schrittweise für jeden einzelnen zu erzeugenden Halbleiterschaltkreis projiziert. Daraus wird ersichtlich, dass es von großer Bedeutung ist, dass die Retikel eine fehlerfreie Abbildung liefern, denn fehlerbehaftete Abbildungen können zu späteren Funktionsstörungen in den Halbleiterschaltkreisen führen und infolge der Mehrfachbelichtung würden auch die Fehler mehrfach reproduziert werden.

Eine Fehlerquelle könnten Partikel darstellen, die auf der Fotomaske oder auf der Glasplatte des Retikels aufliegen. Diese würden dann als Schatten auf der Fotolackschicht abgebildet und damit einen Fehler in der Lackmaske erzeugen. Aus diesem Grunde ist es beispielsweise aus der japanischen Patentanmeldung 04081757 bekannt, Pellikel zu verwenden. Bei den Pellikel handelt es sich um dünne transparente Folien, die in einem Abstand parallel zu der Fotomaske und/oder der Oberfläche der Glasplatte gespannt werden. Hierzu wird ein Pellikelrahmen verwendet, der die Fotomaske ringförmig umschließt. Auf den Pellikelrahmen wird dann das Pellikel gespannt.

Damit lagern sich nun schädliche Partikel auf dem Pellikel und nicht mehr auf der Fotomaske ab und liegen damit außerhalb des Fokusbereiches der Fotomaske, wodurch Partikel bis zu einer Maximalgröße keine negativen Auswirkungen mehr ausüben können.

Ein verfahren und eine Anordnung der eingangs genannten Art ist aus der EP 1 052 547 A2 bzw. der US 6,414,744 B1 bekannt. Darin werden mit einem Pellikel versehene Retikel in einem Magazin bevorratet, um bei entsprechenden fotolithografischen Schritten mittels eines Manipulators aus dem Magazin genommen und in die Belichtungsstation eingeführt zu werden.

Da Retikel aufgrund der hohen Prozessanforderungen, die daran gestellt werden, sehr wertvoll sind, sind in der oben genannten Druckschrift Kontroll- und Regelungsmittel, wie Positionssensoren, vorgesehen, die eine genaue Handhabung innerhalb des Systems vorsehen, um Beschädigungen, die in Folge eines falschen Handlings durch den Manipulator verursacht würden, zu vermeiden.

In der Praxis zeigt es sich jedoch, dass zwar innerhalb eines Handhabungsablaufes ausreichende Sicherheitsmaßnahmen ergriffen werden können, um ein falsches Handling zu vermeiden, dass aber eine große Gefahr darin besteht, dass Retikel verschiedener Hersteller, die wiederum mit Pellikeln verschiedener Hersteller versehen sein können und/oder verschiedenartige Magazine in den fotolithografischen Prozess eingeführt werden können. Die Elemente, wie Retikel, Pellikel und Magazine, von verschiedenen Herstellern zeigen unterschiedliche geometrische Parameter. Da jedoch in aller Regel der Manipulator nur auf einen Toleranzbereich dieser geometrischen Parameter eingestellt werden kann, besteht die Möglichkeit, dass eines dieser Elemente in den fotolithografischen Prozess eingesetzt wird, wobei deren geometrische Parameter außerhalb des Toleranzbereiches liegen. Dies kann dann zu Beschädigungen oder Zerstörungen des Retikels führen, was in Folge deren Werthaltigkeit erhebliche ökonomische Verluste nach sich zieht.

Zwar ist es bekannt, Retikel mit einer eindeutigen Kodierung, beispielsweise einem Barcode, zu versehen. Grundsätzlich bestünde die Möglichkeit, diese Kodierung zur Verhinderung des Einsatzes falscher Retikel zu nutzen. Allerdings geben diese Kodierungen keine Auskunft über später aufgebrachte Pellikel oder über die Magazine, in die die Retikel eingesetzt werden. Die Pellikel aber beispielsweise können, je nach Hersteller, unterschiedliche Höhen aufweisen, die außerhalb des Toleranzbereiches liegen können.

In der US 5,980,187 ist eine Ladestation für Masken beschrieben und dargestellt. In der Ladestation sind zahlreiche Sensoren angeordnet, die die Lage der Retikel feststellen. Diese Sensoren dienen der Maschinensicherheit, indem kritische Zustände, beispielsweise Fehllagen, falsche Retikel oder Retikel ohne Pellikel, erkannt werden und dadurch die Bewegung des Manipulators ausgeschaltet wird.

In EP 0 940 721 ist ein Retikelmagazin beschrieben, bei dem eine Erkennung der Retikel in dem Magazin selbst erfolgt. Dazu sind die Retikel an ihrer Vorderseite mit einem Barcode-Aufkleber versehen, der mit Barcodelesern in einer Vordertüre des Magazins korrespondiert, so dass genau festgestellt werden kann, in welchem Fach sich ein Retikel befindet und jedes Retikel genau identifiziert werden kann.

Bei dieser Lösung ist es allerdings erforderlich, dass jedes Retikel an seiner Vorderseite mit dieser Kennung versehen ist. Allerdings wird dadurch der Einsatz von Retikeln verschiedener Hersteller erschwert, da eine derartige Kennzeichnung eine Standardisierung erfordern-wtirde.

In ähnlicher Art und Weise ist auch die Lösung nach der US 2001/020643 aufgebaut. Hierin ist ein Barcode-Reader in verschiedenen Anordnungen beschrieben. Auch hier ist vorgesehen, dass auf den Vorderseiten der Retikel Barcodes angebracht sind. Weiterhin ist das Magazin derart ausgestaltet, dass die Vorderseite durchsichtig ist, so dass der Barcodereader durch die Vorderseite die Retikelkennzeichnung erkennen kann.

Hierbei ist es ebenfalls erforderlich, dass sich alle Retikelhersteller dem Erfordernis unterwerfen müssten, an der Vorderseite der Retikel eine Kennzeichnung vorzusehen, wodurch sich im Umkehrschluss der diese Lösung nur einsetzbar ist, wenn Retikel mit einer Vorderseitenkennzeichnung Verwendung finden.

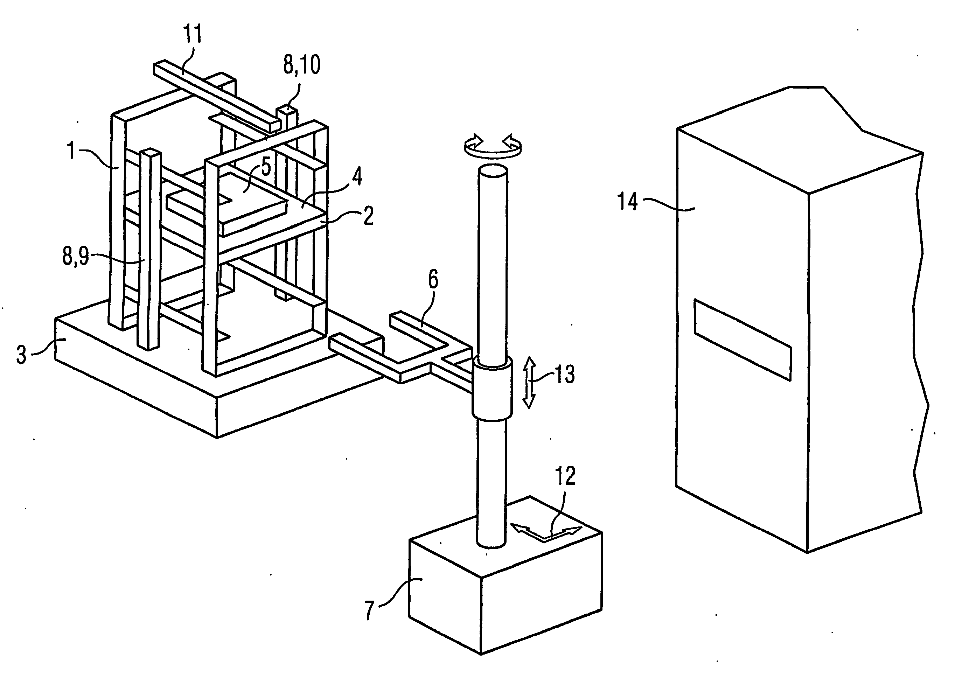

Die US 5,442,163 bezieht sich ebenfalls auf ein Lösung unter Nutzung des Barcodes. Allerdings erfolgt auch hier ein Detektieren der Identität eines Retikel, wie Fig. 4 dargestellt erst nach Entnehmen eines Retikel aus dem Magazin. Damit kann eine Beschädigung des Retikel durch den Manipulator bei dem Eingriff in das Magazin nicht ausgeschlossen werden.

In der JP 07 161703 ist ein Verfahren beschrieben, bei dem Retikel aus einem Magazin entnommen oder in ein Magazin gegeben werden, wobei mittels eines Barcode auf den Magazinen und den Retikel und einem entsprechenden Barcodereader sicher gestellt werden soll, dass diese Beschickung und Entnahme jeweils für die Retikel in oder aus den entsprechend richtigen Magazinen erfolgt.

Die Aufgabe der Erfindung besteht somit darin, beim Einsatz bei fotolithografischen Prozessen zu den Manipulator so in seiner Lage zu steuern, dass beim Einsatz unterschiedlicher Retikel, Retikel-/Pellikel-Paarungen oder Magazinen Beschädigungen oder Zerstörungen, zumindest des Retikels vermieden werden.

Anorclnungsseitig wird die Erfindung dadurch gelöst, dass in der Magazinaufnahme ein erster Sensor seitlich neben dem Aufnahmefach angeordnet ist und aus einer die Höhe eines Retikels und Pellikels feststellenden ersten und zweiten Sensorleiste besteht.

Ein derartiger Sensor kann ermitteln, welches Retikel mit welchem Pellikel in dem Ein- und Ausgabemagazin eingebracht ist. Auch kann ein solcher Sensor erkennen, welches Ein- und Ausgabemagazin eingesetzt worden ist. Im Ergebnis dieser Erkenntnis kann dann der Manipulator zumindest so gesteuert werden, dass er nicht in der Art und Weise in das Aufnahmefach einfahrt, dass Retikel oder Pellikel beschädigt werden.

Weiterhin wird es auch möglich, mittels des Sensors gleich am Anfang des fotolithografischen Prozesses zu erkennen, welche Retikel mit welchem Pellikel am Eingang des fotolithogTafischen Prozesses eingespeist werden, um somit auch nachfolgende Handlingschritte zu steuern.

In einer Ausgestaltung der e-rfiridungsgemäßen Anordnung ist vorgesehen, dass der Sensor aus mehreren räumlich voneinander getrennt angeordneten Teilsensoren besteht. Mittels der Teilsensoren können verschiedene Reaktionen von ausgesandten oder empfangenen Signalen dahingehend ausgewertet werden, dass damit eine Information über die räumliche Erstreckung des Retikels oder Pellikels gewonnen wird. Hier sind eine Zeile von LED's oder mehrere hintereinander liegende Reflexlichtschranken einsetzbar. Aus den bekannten Koordinaten dieser Teilsensoren und deren feststellbaren Reaktionen können dann die benötigten Informationen ermittelt werden.

In einer weiteren Ausgestaltung ist vorgesehen, dass der erste Sensor als Durchlichtsensor derart ausgebildet ist, dass er mit einer ersten und einer zweiten Sensorleiste versehen ist und die erste Sensorleiste mehrere Lichtsender enthält, mit denen Lichtempfänger in der zweiten Sensorleiste korrespondieren, wobei Lichtsender und Lichtempfänger in der jeweiligen Sensorleiste übereinander angeordnet sind.

In einer weiteren Ausgestaltung der Erfindung ist ein zweiter Sensor oberhalb des Ein-Ausgabemagazines angeordnet. Damit kann ein Bild von der Draufsicht auf Retikel mit Pellikel erfasst werden.

In einer besonderen Ausführungsform ist hierzu vorgesehen, dass der erste und/oder der zweite Sensor aus einem CCD-Sensor besteht. Mit einem solchen Sensor kann sogar ein seitliches Abbild des Retikels mit dem Pellikel aufgenommen werden und somit eine sehr genaue Aussage über die geometrischen Erstreckungen gewonnen werden.

Mit einem ersten verfahren wird die Aufgabe dadurch gelöst, dass die Höhe des Retikels mit Pellikel gemessen und der Manipulator in seiner Höhe gesteuert und/oder bei vorliegen eines Grenzwertes der Höhe der Eingriff des Manipulators in das Aufnahmefach gesperrt wird.

Diese gemessenen Daten können eingesetzt werden, wobei die Möglichkeit der Steuerung der Bewegungen des Manipulators genau so bestehen, wie - eine entsprechende Speicherung vorausgesetzt - eine Steuerung nachfolgender Prozesse möglich wird.

Bei den geometrischen Abmessungen handelt es sich um Daten, die die Bauelemente eindeutig kennzeichnen, wodurch der Manipulator entsprechend diesen geometrischen Abmessungen gesteuert wird.. Es ist also nicht unbedingt erforderlich, zusätzliche Daten aufzubringen.

Die Pellikelhöhe ist die sensibelste Größe bei dem Verfahren, die in jedem Falle bei der Steuerung des Manipulators zu beachten ist. In sofern kann schon mit der Kenntnis der pellikelhöhe die erfindungsgemäße Aufgabenstellung gut erfüllt werden.

Ein zweites Verfahren löst die Aufgabe dadurch, dass auf das Retikel oder das Pellikel ein die Pellikel-/Retikel-Paarung kennzeichnender Code als signifikantes Datum aufgebracht wird. Dabei ist vorgesehen, die Retikel-/Pellikel-Paarung mit einem Transponder zu versehen, in den das signifikante Datum eingesehriebein wird und der Transponder zur Steuerung des Manipulators vor einem Einfahren des Manipulators in das Aufnahmefach ausgelesen wird.

Hierbei ist es von besonderem Vorteil, dass die benötigten Informationen auch über relativ große Entfernungen ausgelesen werden können. Auch können die Transponder eine Vielzahl von Informationen enthalten, beispielsweise über die Benutzungshäufigkeit eines Retikels, die im weiteren Prozess gelesen, geschrieben oder fortgeschrieben werden.

Ein solches Datum - dessen exakte Korrelation mit den bestehenden Gegebenheiten vorausgesetzt - kann in aller Regel mit relativ einfachen technischen Mitteln sehr genau ausgelesen und zur weiteren Steuerung verwendet werden. Auch können sich damit geometrische Fehlereinflüsse, wie sie bei jeder Messung von beispielsweise geometrischen Parametern entstehen können, vermeiden lassen**.**

Die Erfindung soll nachfolgend anhand eines Ausführungsbeispieles näher erläutert werden. Die zugehörige Zeichnung zeigt eine schematischen Darstellung einer erfindungsgemäßen Anordnung.

Ein Ein-/Ausgabemagazin 1 weist ein Aufnahmefach 2 auf, in das vor der Beschickung einer Magazinaufnahme 3 mit dem Ein-/Ausgabemagazin 1 ein Retikel 4 mit einem darauf angeordneten Pellikel 5 eingeschoben wurde.

Zur Entnahme des Retikels 4 aus dem Ein-/Ausgabemagazin 1 ist ein Manipulator 6 vorgesehen, der über eine Antriebseinheit 7 relativ zu dem Ein-/Ausgabemagazin 1 bewegbar ist.

Weiterhin ist ein erster Sensor 8 vorgesehen, der in der Magazinaufnahme so angeordnet ist, dass damit die Höhe des Retikels 4 und Pellikels 5 festgestellt werden kann. Dieser Sensor 8 besteht seinerseits aus einer ersten Sensorleiste 9 und einer zweiten Sensorleiste 10. In der ersten Sensorleiste 9 sind übereinander mehrere Lichtsender und in der zweiten Sensorleiste 10 entsprechende übereinander angeordnete Lichtempfänger angeordnet, womit der erste Sensor 8 nach dem Prinzip der Durchsichtlichtschranken arbeitet, in deren Strahlengang Retikel 4 mit Pellikel 5 liegen. Je nachdem wie hoch nun beispielsweise das Pellikel 5 ist, desto mehr oder weniger Strahlengänge der Lichtschranken werden unterbrochen, so dass sich an der zweiten Sensorleiste 10 ein Abbild der Höhe des Pellikels 5 abzeichnet.

Weiterhin ist ein zweiter Sensor 11 vorgesehen, der oberhalb des Ein-/Ausgabemagazines angeordnet ist. Dieser ist als CCD-Sensor ausgeführt, der ein Bild von der Draufsicht auf Retikel 4 mit Pellikel 5 erfasst.

Nunmehr wird über die Antriebseinheit 7 die Horizontalbewegung 12 und die Vertikalbewegung 13 des Manipulators 6 so gesteuert, dass dieser das Retikel 4 in jedem Falle beschädigungsfrei aus dem Aufnahmefach 2 des Ein-/Ausgabemagazins 1 entnehmen kann, unabhängig von dessen Ausmessungen und der Höhe des Pellikels 5. Anschließend fährt der Manipulator 6 das entnommene Retikel 4 in eine Eingabestation 14 für den nachfolgenden fotolithografischen Prozess ein.

### Bezugzeichenliste

- 1: Ein-/Ausgabemagazin
- 2: Aufnahmefach
- 3: Magazinaufnahme
- 4: Retikel
- 5: Pellikel
- 6: Manipulator
- 7: Antriebseinheit
- 8: erster Sensor
- 9: erste Sensorleiste
- 10: zweite Sensorleiste
- 11: zweiter Sensor
- 12: Horizontalbewegung
- 13: Vertikalbewegung
- 14: Eingabestation

## Patentansprüche

1. Anordnung zur Ein- und Ausgabe von Retikeln in fotolithografischen Prozessen mit einer Magazinaufnahme, in die ein Ein- und Ausgabemagazin, in dem zumindest ein horizontales Aufnahmefach zur Aufnahme eines mit einem Pellikel versehenen Retikels vorgesehen ist, einsetzbar ist, einem Manipulator, einer das Retikelmagazin und/oder den Manipulator relativ zueinander bewegenden Antriebseinheit und einem mit dem Retikel korrespondierenden Sensor der die Antriebseinheit steuernd zumindest mittelbar mit dieser verbunden ist **dadurch gekennzeichnet , dass** in der Magazinaufnahme ein erster Sensor (8) seitlich neben dem Aufnahmefach angeordnet ist und aus einer die Höhe eines Retikels und Pellikels feststellenden ersten und zweiten Sensorleiste (9; 10) besteht.

2. Anordnung nach Anspruch 1, **dadurch gekennzeichnet, dass** der erste Sensor (8) aus aus mehreren räumlich voneinander getrennt angeordneten Teilsensoren besteht.

3. Anordnung nach Anspruch 1 oder 2, **dadurch gekennzeichnet , dass** der erste Sensor (8) als Durchlichtsensor derart ausgebildet ist, dass er mit einer ersten (9) und einer zweiten Sensorleiste (10) versehen ist und die erste Sensorleiste (9) mehrere Lichtsender enthält, mit denen Lichtempfänger in der zweiten Sensorleiste (10) korrespondieren, wobei Lichtsender und Lichtempfänger in der jeweiligen Sensorleiste (9; 10) übereinander angeordnet sind.

4. Anordnung nach einem der Ansprüche 1 bis 3 , **dadurch gekennzeichnet , dass** ein zweiter Sensor (11) oberhalb des Ein-Ausgabemagazines (1) angeordnet ist.

5. Anordnung nach Anspruch 1, 2 oder 4, **dadurch gekennzeichnet , dass** der erste Sensor (8) und/oder der zweite Sensor (11) aus einem CCD-Sensor besteht.

6. Verfahren zur Ein- und Ausgabe von Retikein in fotolithografischen Prozessen bei dem mit Pellikeln versehene Retikel nach einem Einsetzen eines Ein- und Ausgabemagazines in eine mittels eines Manipulators aus einem Aufnahmefach des Ein- und Ausgabemagazines aufgenommen und dem fotolithografischen Prozess zugeführt werden, wobei von dem Retikel (4) signifikante Daten aufgenommen werden und mittels dieser Daten die Bewegung des manipulators (6) gesteuert werden, **dadurch gekennzeichnet, dass** die Höhe des Retikels (4) mit Pellikel (5) gemessen und der Manipulator (6) in seiner Höhe gesteuert und/oder bei Vorliegen eines Grenzwertes der Höhe der Eingriff des Manipulators (6) in das Aufnahmefach (2) gesperrt wird.

7. Verfahren zur Ein- und Ausgabe von Retikeln in fotolithografischen Prozessen, bei dem mit Pellikeln versehene Retikel -nach- einem Einsetzen eines. Ein- und Ausgabemagazines in eine mittels eines Manipulators aus einem Aufnahmefach des Ein- und Ausgabemagazines aufgenommen und dem fotolithografischen Prozess zugeführt werden, wobei von dem Retikel (4) signifikante Daten aufgenommen werden und mittels dieser Daten die Bewegung des Manipulators (6) gesteuert werden, **dadurch gekennzeichnet , dass** auf das Retikel (4) oder das Pellikel (5) ein die Pellikel-/Retikel-Paarung kennzeichnender Code als signifikantes Datum aufgebracht wird, wozu die Retikel-/Pellikel-Paarung mit einem Transponder versehen wird, in den das signifikante Datum eingeschrieben wird und der Transponder zur Steuerung des Manipulators (6) vor einem Einfahren des Manipulators (6) in das Aufnahmefach (2) ausgelesen wird.

## Claims

1. Arrangement for the input and output of reticles in photolithographic processes, comprising a magazine holder, into which an input and output magazine, in which at least one horizontal holding compartment for holding a reticle provided with a pellicle is provided, can be inserted, a manipulator, a drive unit which moves the reticle magazine and/or the manipulator relative to each other, and a sensor corresponding with the reticle, which, controlling the drive unit, is at least indirectly connected to the latter, **characterized in that** a first sensor (8) is arranged in the magazine holder laterally beside the holding compartment and comprises a first and a second sensor strip (9; 10) determining the height of a reticle and pellicle.

2. Arrangement according to Claim 1, **characterized in that** the first sensor (8) comprises a plurality of part sensors arranged physically separated from one another.

3. Arrangement according to Claim 1 or 2, **characterized in that** the first sensor (8) is formed as a transmitted light sensor, **in that** it is provided with a first (9) and a second sensor strip (10) and the first sensor strip (9) contains a plurality of optical transmitters, with which optical receivers in the second sensor strip (10) correspond, optical transmitters and optical receivers in the respective sensor strip (9; 10) being arranged above one another.

4. Arrangement according to one of Claims 1 to 3, **characterized in that** a second sensor (11) is arranged above the input-output magazine (1).

5. Arrangement according to Claim 1, 2 or 4, **characterized in that** the first sensor (8) and/or the second sensor (11) comprises a CCD sensor.

6. Method for the input and output of reticles in photolithographic processes, in which reticles provided with pellicles, following the insertion of an input and output magazine into one, are picked up by means of a manipulator from a holding compartment of the input and output magazine and are fed to the photolithographic process, significant data being picked up from the reticle (4) and the movement of the manipulator (6) being controlled by means of these data, **characterized in that** the height of the reticle (4) with pellicle (5) is measured and the manipulator (6) is controlled vertically and/or, if there is a limiting value of the height, the manipulator (6) is barred from reaching into the holding compartment (2).

7. Method for the input and output of reticles in photolithographic processes, in which reticles provided with pellicles, following the insertion of an input and output magazine into one, are picked up by means of a manipulator from a holding compartment of the input and output magazine and are fed to the photolithographic process, significant data being picked up from the reticle (4) and the movement of the manipulator (6) being controlled by means of these data, **characterized in that** a code identifying the pellicle/reticle pairing is applied to the reticle (4) or the pellicle (5) as a significant item of data, for which purpose the reticle/pellicle pairing is provided with a transponder, into which the significant item of data is written, and the transponder is read out in order to control the manipulator (6) before the manipulator (6) is moved into the holding compartment (2).

## Revendications

1. Arrangement pour l'introduction et l'extraction de réticules dans les processus de photolithographie comprenant un logement pour chargeur dans lequel peut s'enclencher un chargeur d'introduction et d'extraction dans lequel est prévu au moins un casier d'accueil horizontal destiné à l'accueil d'un réticule muni d'une pellicule, un manipulateur, une unité d'entraînement qui déplace le chargeur de réticules et/ou le manipulateur l'un par rapport à l'autre et un capteur correspondant au réticule qui est relié au moins indirectement avec l'unité d'entraînement et la commande, **caractérisé en ce qu'**un premier capteur (8) est disposé dans le logement pour chargeur latéralement à côté du casier d'accueil et se compose d'une première et d'une deuxième baguette de détection (9; 10) qui déterminent la hauteur d'un réticule et d'une pellicule.

2. Arrangement selon la revendication 1, **caractérisé en ce que** le premier capteur (8) se compose de plusieurs capteurs partiels disposés séparément les uns des autres dans l'espace.

3. Arrangement selon la revendication 1 ou 2, **caractérisé en ce que** le premier capteur (8) est réalisé sous la forme d'un capteur par transmission de telle sorte qu'il est muni d'une première (9) et d'une deuxième baguette de détection (10) et la première baguette de détection (9) comprend plusieurs émetteurs de lumière auxquels correspondent des récepteurs de lumière dans la deuxième baguette de détection (10), les émetteurs de lumière et les récepteurs de lumière dans les baguettes de détection (9 ; 10) respectives étant disposés les uns au-dessus des autres.

4. Arrangement selon l'une des revendications 1 à 3, **caractérisé en ce qu'**un deuxième capteur (11) est disposé au-dessus du chargeur d'introduction et d'extraction (1).

5. Arrangement selon la revendication 1, 2 ou 4, **caractérisé en ce que** le premier capteur (8) et/ou le deuxième capteur (11) se compose d'un capteur CCD.

6. Procédé pour l'introduction et l'extraction de réticules dans les processus de photolithographie avec lequel des réticules munis de pellicules, après l'insertion d'un chargeur d'introduction et d'extraction, sont sortis au moyen d'un manipulateur d'un casier d'accueil du chargeur d'introduction et d'extraction et acheminés au processus de photolithographie, des données importantes étant enregistrées sur le réticule (4) et le mouvement du manipulateur (6) étant commandé au moyen de ces données, **caractérisé en ce que** la hauteur du réticule (4) avec la pellicule (5) est mesurée et le manipulateur (6) est commandé en hauteur et/ou, en présence d'une valeur limite de la hauteur, l'intervention du manipulateur (6) dans le casier d'accueil (2) est bloquée.

7. Procédé pour l'introduction et l'extraction de réticules dans les processus de photolithographie avec lequel des réticules munis de pellicules, après l'insertion d'un chargeur d'introduction et d'extraction, sont sortis au moyen d'un manipulateur d'un casier d'accueil du chargeur d'introduction et d'extraction et acheminés au processus de photolithographie, des données importantes étant enregistrées sur le réticule (4) et le mouvement du manipulateur (6) étant commandé au moyen de ces données, **caractérisé en ce qu'**un code caractérisant la paire réticule/pellicule est appliqué sur le réticule (4) ou sur la pellicule (5) en tant que date significative, la paire réticule/pellicule étant munie à cet effet d'un transpondeur dans lequel la date significative étant enregistrée et le transpondeur étant lu en vue de la commande du manipulateur (6) avant une introduction du manipulateur (6) dans le casier d'accueil (2).
